# EUROPEAN PATENT APPLICATION

(11) **EP 1 950 324 A2**
(43) Date of publication of application: **30.07.2008**
(21) Application number: 08250254.3
(22) Date of filing: 19.01.2008
(51) Int. Cl.: C23C 18/06, C23C 18/08, C23C 18/16, C23C 18/31

(54) **Method of forming metal pattern, and metal salt mixture**

(30) Priority: 26.01.2007 JP 2007016143
(71) Applicant: Konica Minolta Holdings, Inc., Tokyo 100-0005 (JP)
(72) Inventor: Tomatake, Atsushi, Hino-Shi Tokyo 191-8511 (JP); Iijima, Hirotaka, Hino-Shi Tokyo 191-8511 (JP)
(74) Representative: Alton, Andrew

(57) **Abstract**

An objective is to provide plate making printing exhibiting conductivity and flexibility with respect to a flexible substrate, and to provide a method of forming metal patterns via non-plate making printing, and a metal salt mixture usable for the method. Also disclosed is a method of forming a metal pattern possessing the steps of conducting patterning on a substrate with a metal salt mixture for the metal pattern formation possessing a metal salt and a reducing agent, and having a viscosity of 3 - 50 mPa·s at 25 °C, and forming the metal pattern via heating to a temperature of 80 - 400 °C.

## Description

This application claims priority from Japanese Patent Application No. 2007-016143 filed on January 26, 2007, which is incorporated hereinto by reference.

### TECHNICAL FIELD

The present invention relates to a metal pattern forming method, and specifically to a metal pattern forming method utilized for a circuit.

### BACKGROUND

Formation of metal patterns utilized for a circuit has been conducted with a forming method employing a conventional resist material.

That is, the resist material was coated on a metal thin film, the undesired resist was removed by exposing the metal pattern to light, and the exposed metal thin film was removed via etching. Further, the metal thin layer having recorded metal patterns has been formed by peeling off the remaining resist portion.

However, in this method, a great deal of wastefulness is produced in view of production time, and usability efficiency of energy and raw material such that a long duration is consumed for various processes, and the undesired resist is desired to be removed, whereby improvements thereof have been demanded.

Attention has recently been focused on a method of forming metal patterns by which the metal patterns are made directly with screen printing employing ink containing metal nanoparticles having a particle diameter of 100 nm or less (refer to Patent Documents 1 and 2, for example).

This method to form a circuit utilizes that a melting point drops by minimizing this particle diameter, and a baking process is conducted at comparatively low temperature of 200 - 300 °C.

The present technique has advantages of man-hour reduction as well as usability efficiency of raw material, but there are still problems such that metal particle-to-metal particle is difficult to be perfectly fused, and electrical resistance of the metal pattern after baking does not drop to an electrical resistance level of a bulk metal.

In order to solve these problems, disclosed is a technique of directly forming a copper layer in which a metal ion solution obtained by adding alkoxyalkylamine into copper formate is brought into contact with a substrate via heating (refer to Patent Document 3, for example).

On the other hand, a reducible metal compound, a reducing agent capable of reducing the metal compound and a physical development nucleus as catalyst action in reduction of the metal compound to a metal are provided on a substrate having an ink receptive layer, whereby disclosed is a technique of forming metal images exhibiting high optical density by producing reducing reaction mainly for the physical development nucleus (refer to Patent Document 4, for example).
(Patent Document 1) Japanese Patent O.P.I. Publication No. 2002-299833
(Patent Document 2) Japanese Patent O.P.I. Publication No. 2004-119686
(Patent Document 3) Japanese Patent O.P.I. Publication No. 2005-2471
(Patent Document 4) Japanese Patent O.P.I. Publication No. 8-52936

### SUMMARY

However, after considerable effort during intensive studies, the inventors have found out that a convection flow inside a copper salt mixture becomes insufficient since viscosity of the mixture is high in the case of the foregoing Patent Document 3, whereby reducing reaction progresses locally, and the resulting copper layer becomes uneven easily, resulting in a problem such as degraded flexibility.

Specifically in the case of Patent Document 3 applied to a so-called flexible substrate, it was found out that there was a problem such that cracks caused by bending was easy to be generated from uneven portions inside a layer, and a copper layer was easy to be peeled off the substrate via repetitive bending, whereby internal resistance was further to be raised.

The copper layer formed also in the similar reason tends to produce a roughened surface of a substrate, exhibits inflexibility of the layer, and has caused peeling together with degradation of internal resistance.

According to the foregoing Patent Document 4, it was also found out that there was another problem such that stiffness was inferior as a layer since metal particles in which the physical development nucleus was mainly grown formed a metal layer, cracks caused by bending was easy to be generated from uneven portions inside the layer, and a copper layer was easy to be peeled off the substrate via repetitive bending, whereby internal resistance was further to be raised.

Further, the reducing reaction speed of mainly physical development nucleus is high, and as a result, growth of metal particles presumably becomes larger, since viscosity of the liquid employed in Patent Document 4 is too low.

It is an object of the present invention to provide plate making printing exhibiting conductivity and flexibility with respect to a flexible substrate, and to provide a method of forming metal patterns via non-plate making printing, and a metal salt mixture usable for the method according to the above-described situation.

### DESCRIPTION OF THE PREFERRED EMBODIMENTS

The above object of the present invention is accomplished by the following structures.
(Structure 1) A method of forming a metal pattern comprising the steps of conducting patterning on a substrate with a metal salt mixture for the metal pattern formation comprising a metal salt and a reducing agent, and having a viscosity of 3 - 50 mPa·s at 25 °C; and forming the metal pattern via heating.
(Structure 2) The method of Structure 1, wherein the metal salt mixture further comprises a solvent.
(Structure 3) The method of Structure 1 or 2, wherein the metal is gold, silver, copper, platinum, palladium or nickel.
(Structure 4) The method of Structure 3, wherein the metal is copper.
(Structure 5) The method of any one of Structures 1 - 4,
   wherein no physical development nucleus is substantially contained in the metal salt mixture and on a substrate.
(Structure 6) The method of any one of Structures 1 - 5,
   wherein the metal salt mixture has a viscosity of 3.5 - 40 mPa·s at 25 °C.
(Structure 7) The method of Structure 6,
   wherein the metal salt mixture has a viscosity of 4 - 30 mPa·s at 25 °C.
(Structure 8) The method of any one of Structures 1 - 7,
   wherein the metal salt mixture has a surface tension of 20 - 60 mN/m.
(Structure 9) The method of Structure 8, wherein the metal salt mixture has a surface tension of 25 - 50 mN/m.
(Structure 10) The method of any one of Structures 1 - 9, wherein the metal salt mixture comprises water.
(Structure 11) The method of any one of Structures 2 - 10, wherein the metal salt mixture comprises a water-soluble organic solvent as the solvent.
(Structure 12) The method of any one of Structures 2 - 9, wherein the metal salt mixture comprises a water-insoluble organic solvent as the solvent.
(Structure 13) The method of any one of Structures 1 - 12, wherein the substrate is flexible.
(Structure 14) The method of any one of Structures 1 - 13, wherein the metal pattern has a line width of 10 - 200 µm.
(Structure 15) The method of any one of Structures 1 - 13, wherein the heating temperature is 80 - 800 °C.
(Structure 16) A metal salt mixture for metal pattern formation, wherein the metal salt mixture comprising a metal salt and a reducing agent has a viscosity of 3 - 50 mPa·s at 25 °C.
(Structure 17) The metal salt mixture Structure 16, further comprising a solvent.
(Structure 18) The metal salt mixture of Structure 16 or 17, wherein the metal is gold, silver, copper, platinum, palladium or nickel.
(Structure 19) The metal salt mixture of Structure 18,
   wherein the metal is copper.
(Structure 20) The metal salt mixture of any one of Structures 16 - 19, substantially comprising no physical development nucleus.
(Structure 21) The metal salt mixture of any one of Structures 16 - 20, having a viscosity of 3.5 - 40 mPa·s at 25 °C.
(Structure 22) The metal salt mixture of Structure 21, having a viscosity of 4 - 30 mPa·s at 25 °C.
(Structure 23) The metal salt mixture of any one of Structures 16 - 22, having a surface tension of 20 - 60 mN/m.
(Structure 24) The metal salt mixture of Structure 23, having a surface tension of 25 - 50 mN/m.
(Structure 25) The metal salt mixture of any one of Structures 16 - 24, comprising water.
(Structure 26) The metal salt mixture of any one of Structures 17 - 25, comprising a water-soluble organic solvent as the solvent.
(Structure 27) The metal salt mixture of any one of Structures 17 - 24, comprising a water-insoluble organic solvent as the solvent.

While the preferred embodiments of the present invention have been described using specific terms, such description is for illustrative purposes only, and it is to be understood that changes and variations may be made without departing from the spirit or scope of the appended claims.

### DETAILED DESCRIPTION OF THE INVENTION

The present invention will be described in detail. (Method of forming pattern)

In the present invention, a metal pattern is made with a metal salt mixture possessing a metal salt and a reducing agent, and having a viscosity of 3 - 50 mPa·s at 25 °C.

The inventors have found out that in the case of application of a metal salt mixture exhibiting high viscosity, there is a problem such that flexibility is deteriorated as described before. The reason is that a convection flow inside a salt mixture becomes insufficient since viscosity of the mixture is high, reducing reaction of a metal ion progresses locally, and presumably, a structure inside the resulting metal pattern becomes locally uneven. When there are such the locally uneven portions, fine cracks are generated from these portions via repetitive bending, whereby adhesion to a substrate is presumably deteriorated. Further, internal resistance is increased because of presence of such the fine cracks, whereby desired conductivity in metal patterns tends to be degraded.

Since high viscosity also causes deterioration in fluidity, in the case of presence of the roughened surface of a substrate, the roughened surface tends to be reflected to the surface of the resulting metal pattern. Because of this, flexibility of the resulting metal pattern becomes insufficient, and as a result, peeling and degradation in internal resistance are presumably caused.

The inventors have found out that the above-described problem can be avoided by utilizing viscosity of a metal salt mixture having 50 mPa·s or less as the sufficient fluidity.

On the other hand, in the case of very low viscosity, the fluidity becomes too high, and occurrence of easily flowing through the substrate surface happens even though recording was made in the form of a pattern, whereby it becomes difficult to form a precise pattern. Since wettability and liquinert are largely associated with the substrate surface, it can not be completely defined, but it is found out that the minimum demand can be satisfied in the case of at least 3 mPa·s.

In the case of formation of a pattern having a line width of narrower than 200 µm, flowing out onto the surface affects too much when the viscosity is too low, whereby it becomes difficult to form an intended pattern. The above-described is specifically prominent in the case of formation of a pattern having a line width of narrower than 200 µm. However, since a method of forming metal patterns in the present invention has a feature to form fine patterns, a metal pattern having a line width of 10 - 200 µm is preferable, and a metal pattern having a line width of 10 - 100 µm is more preferable.

Further, in the case of a viscosity of less than 3 mPa·s, reducing reaction tends to be locally generated since not only a diffusion rate of a metal salt as well as a reducing agent is increased, but also a reducing reaction rate is increased. Specifically, when present are physical development nuclei such as colloidal noble metal particles (colloidal silver particles, for example) or colloidal heavy metal sulfide particles (colloidal palladium sulfide particles, nickel sulfide particles and silver-nickel sulfide particles, for example), reducing reaction mainly by those is rapidly generated, whereby unevenness inside the metal pattern is to be increased.

To avoid this, a viscosity of at least 3 mPa·s is preferable.

In the same reason as above, no physical development nucleus is preferably contained.

As a means of controlling viscosity, mixing with each of solvents having various kinds of viscosity is taken into account. Viscosity of various solvents (in the case of a single solvent and mixtures obtained from two different kinds of solvents, for example) has been measured in advance. A metal salt is dissolved in a solvent mixture having a composition nearly corresponding to intended viscosity, and fine adjustment is possible to be made by adding a solvent having high or low viscosity.

Viscosity can also be adjusted by adding a ligand or a polymer.

The metal salt mixture of the present invention preferably has a viscosity of 3.5 - 40 mPa·s at 25 °C, and more preferably has a viscosity of 4 - 30 mPa·s at 25 °C.

The patterning method is not specifically limited, provided that it is conventionally used for printing, and examples thereof include a letter press printing method, a planographic printing method, an intaglio printing method, a mimeograph printing method and so forth. Of these, an offset printing method as a kind of planographic printing method, and a screen printing method as a kind of mimeograph printing method are preferable in view of fine patterning.

A non-plate making printing method employing a micro-dispenser or an ink-jet technique is preferably used. Of these, a printing method employing an ink-jet technique is specifically preferable in view of fine patterning and reproducibility.

As the substrate used in the present invention, any substrate is allowed to be used, provided that it exhibits an insulating property, and examples thereof include those having high stiffness such as glass or ceramics, and those in the form of a film composed of PET (polyethylene terephthalate), polyimide or such.

A so-called primer treatment or plasma treatment maybe carried out in order to improve adhesion to a substrate employed in the present invention.

Substrates preferably exhibit no liquid-absorption in the present invention. In the present invention, the substrate has an absorption amount of less than 0.5 g/m² in the case of use of pure water.

After conducting patterning with a metal salt mixture of the present invention on a substrate, reducing reaction and drying are progressed via heating to form a metal pattern on the substrate. A heating temperature is preferably 80 - 800 °C, more preferably 110 - 500 °C, and still more preferably 120 - 250 °C. In the case of a very low heating temperature, reducing reaction with a metal salt becomes insufficient, whereby insufficient conductivity results. On the other hand, in the case of a very high temperature, the inside of the resulting metal pattern becomes uneven since the reducing reaction with the metal salt is rapidly progressed, whereby degradation of adherence results. In addition, when a flexible substrate specifically made of a resin is employed, no pattern can be formed since a resin itself is dissolved at high temperature.

Heating may be conducted in the presence of an unoxidized gas such as nitrogen or argon, but an intended metal pattern can be formed even though heating is conducted in the atmosphere.

### (Metal salt compound)

Preferable examples of the metal include gold, silver, copper, platinum, palladium and nickel. Silver and copper are more preferable, and copper is still more preferable.

The metal salt compound may be water-soluble or oil-soluble. The metal compound exhibiting sufficient solubility is preferable in view of stability of a metal salt mixture and a formed metal layer thickness.

Examples of the salt resistance include an inorganic ion of halide (a chloride ion, a bromide ion and so forth) or of carbonic acid; an organic acid ion of a carboxylic acid (an acetic acid, a palmitic acid, a behenic acid and so forth), or of a sulfonic acid (a methansulfonic acid, a p-toluenesulfonic acid and so forth); and an organic ligand such as alkylamine or acetylacetone.

In such the metal salt compounds, examples of the gold salt compound include gold (III) chloride acid, potassium tetrachloro gold (III) acid and so forth.

Examples of the silver salt compound include silver nitrate, perchloric acid silver (I), acetic acid silver (I), trifluoroacetic acid silver (I) and so forth.

Examples of the copper salt compound include copper (I) chloride, copper (II) chloride, copper (I) bromide, copper (II) bromide, copper (I) iodide, potassium copper(II) chloride, perchloric acid copper (II), copper (II) nitrate, copper (II) sulfate, ammonium copper (II) sulfate, copper (II) carbonate, copper (II) formate, copper (II) acetate, copper (II) 2-ethylhexanoic acid, copper (II) stearic acid, copper (II) trifluoromethanesulfonic acid, copper (II) oxalic acid, copper (II) tartaric acid, copper (II) benzoic acid, copper naphthenate, copper (II) citrate, copper (II) acetylacetonate, copper (II) hexafluoroacetylacetonato, copper (II) benzoylacetonate, ethylenediamine cupric tetraacetic acid, copper(II) oxide, copper hydroxide and so forth.

Examples of the platinum salt compound include platinum chloride, platinum oxide, diaminedinitro platinum (II), dichlorodiamine platinum (II), dichlorotetraammine platinum (II), ammonium tetrachloro platinum (II), hexachloro platinum (IV) acid and so forth.

Examples of the palladium salt compound include a palladium (II) chloride, ammonium palladium (II) chloride, palladium (II) bromide, lithium tetrachloro palladium (II) acid, ammonium hexachloro palladium (IV) acid, palladium (II) nitrate, palladium (II) acetate, palladium (II) trifluoroacetate, palladium (II) oxide and so forth.

Examples of the nickel salt compound include nickel (II) benzoate, nickel (II) fluoride, potassium nickel (IV) fluoride, nickel (II) chloride, nickel (II) bromide, nickel (II) perchloric acid, nickel (II) nitrate, nickel (II) sulfate, ammonium nickel (II) sulfate, nickel carbonate, nickel (II) acetate, nickel stearate, nickel (II) sulfamate, nickel (II) oxalate, nickel trifluoromethansufonate, nickel (II) acetylacetonate, nickel (II) hydroxide and so forth.

An addition amount of the metal salt compound is preferably 5 - 40% by weight, provided that it falls in the above-described range of viscosity.

### (Reducing agent)

The reducing agent is not particularly limited, provided that the reducing agent is utilized as a commonly usable reducing agent.

A reducing agent such as organic amine or alcohol exhibiting weak reducing capability is also usable.

Preferable examples of the reducing agent include hydrazine and hydrazines such as methylhydrazine, 1, b1-dimethylhydrazine, 1, 2-dimethyl hydrazine, t-butyl hydrazine, benzyl hydrazine, 2-hydrazinoethanol, 1-n-butyl-1-phenyl hydrazine, phenyl hydrazine, 1-naphthyl hydrazine, 4-chlorophenyl hydrazine, 1, 1-diphenyl hydrazine, p-hydrazino benzene sulfonic acid, 1, 2-diphenyl hydrazine, acetyl hydrazine, benzoyl hydrazine and derivatives thereof.

Other examples thereof include hydroxylamine and hydroxylamines such as N-(t-butyl) hydroxylamine, N, N-dimethyl hydroxylamine, N, N-diethyl hydroxylamine, N-methyl hydroxylamine, N, N-bis (2-methoxyethyl) hydroxylamine, N-ethyl-N-tetrahydrofurfuryl hydroxylamine, disulfoethyl hydroxylamine, dicarboxyethyl hydroxylamine and derivatives thereof .

Further, examples thereof include aromatic diamines such as p-phenylene diamine, o-phenylene diamine, N, N-diethyl-p-phenylene diamine and N-(2-hydroxyethyl)-N-ethyl-3-methyl-p-phenylene diamine.

Other examples thereof include an ascorbic acid, an erythorbic acid, a glyoxylic acid, formaldehyde, glyoxal, glucose, hydroquinone, 2-methyl hydroquinone, a gallic acid and a citrazinic acid.

Further, examples of the reducing agent exhibiting weak reducing capability include hydroxycarboxylic acids such as a citric acid and a tartaric acid; hydroxyketone such as acetoin; alkylamines such as butylamine, diazabicyclo [2, 2, 2] octane, ethylene diamine and triethanol amine; amino acids such as glycin and alanine; glycols such as diethylene glycol and dipropylene glycol monomethyl ether; and derivatives thereof.

These reducing agents may be anhydride or hydrate, and those may also be salts of inorganic acids such as a hydrochloric acid, a sulfuric acid and a carbonic acid, or salts of organic acids such as an acetic acid, a toluenesulfonic acid and a tartaric acid. Further, in the case of having an acidic group as a substituent, those may also be salts of inorganic bases such as sodium and potassium, or salts of organic bases such as ammonia and alkylamine.

An addition amount of the reducing agent is preferably 0.5 - 5 times the amount of the metal salt mixture in molar ratio, provided that it falls in the above-described range of viscosity.

### (Solvent)

A solvent is preferably employed in view of stability of properties.

As the solvent, glycols such as ethylene glycol and derivatives thereof, and as the water-soluble organic solvent, heterocyclic compounds containing a heteroatom such as nitrogen, oxygen or sulfur and derivatives thereof are provided.

Examples of other solvents include water-insoluble solvents such as ketone, ester, aliphatic hydrocarbon and aromatic hydrocarbon.

Examples of such the solvent include alcohols such as methanol, ethanol, propanol, isopropanol, butanol, i-butanol, sec-butanol, t-butanol, pentanol, hexanol, cyclohexanol, benzyl alcohol and dodecyl alcohol; polyhydric alcohols such as ethylene glycol, diethylene glycol, triethylene glycol, polyethylene glycol, propylene glycol, dipropylene glycol, polypropylene glycol, butylene glycol, hexane diol, pentane diol, glycerin, hexane triol, thiodiglycol, 1,3-propanediol, 1,4-butanediol, 1,5-pentanediol, 1, 2-pentane diol, 1, 2-hexane diol and 1, 2, 6-hexane triol; polyhydric alcohol ethers such as ethylene glycol monomethyl ether, ethylene glycol monoethyl ether, ethylene glycol monobutyl ether, diethylene glycol monomethyl ether, diethylene glycol monoethyl ether, diethylene glycol monobutyl ether, propylene glycol monomethyl ether, propylene glycol monobutyl ether, ethylene glycol monomethyl ether acetate, triethylene glycol monomethyl ether, triethylene glycol monoethyl ether, triethylene glycol monobutyl ether, ethylene glycol monophenyl ether, propylene glycol monophenyl ether, diethylene glycol diethyl ether, dipropylene glycol dimethyl ether, diethylene glycol monomethy monoethyl ether and ethylene glycol monoethyl ether acetate; esters such as isopropyl lactate and butyl lactate; amines such as ammonia, ethanolamine, diethanolamine, triethanolamine, N-methyldiethanolamine, N-ethyldiethanolamine, morpholine, N-ethyl morpholine, ethylenediamine, diethylenediamine, triethylenetetramine, tetraethylenepentamine, polyethyleneimine, pentamethyl diethylenetriamine and tetramethylpropylenediamine; amides such as formamide, N, N-dimethylformamide and N, N-dimethylacetamide; heterocycles such as 2-pyrrolidone, N-methyl-2-pyrrolidone, cyclohexyl pyrrolidone, 2-oxazolidone and 1, 3-dimethyl-2-pyrrolidone; sulfoxides such as dimethyl sulfoxide and so forth; sulfones such as sulfolane and so forth; urea; acetonitrile; and ketones such as acetone, methylethyl ketone, cyclohexanone and 2-methylcyclohexanone.

Of these, preferable examples of organic solvents include alcohols, polyhydric alcohols, polyhydric alcohol ethers, esters, heterocycles and ketones.

The addition amount of these solvents is not particularly limited, provided that it falls in the above-described range.

### (Additives)

Various additives may be contained in order to improve properties of a metal salt mixture.

Examples of additives include a fungicide, a surfactant, a smoothing agent, latex and a polymer.

In general, metal ions exhibit antibacterial activity, and generation and propagation of bacteria as well as funguses tend to be prevented without always adding a fungicide. When it is further added, a commercially available organic fungicide is preferably added, and examples thereof include Proxel and Densil produced by Arch Chemicals, Inc., Preventol produced by Lanxess Corp., and Topside produced by Permachem Asia, Ltd.

A surfactant and a smoothing agent can improve not only wettability between a metal salt mixture and a substrate, but also adhesion between the substrate and a metal pattern. The wettability can be evaluated as a reference indicator of the metal salt mixture, and is preferably within the range of 20 - 60 mN/m in terms of surface tension, but more preferably within the range of 25 - 50 mN/m in terms of surface tension. In the case of a surface tension exceeding 60 mN/m, adhesion to a substrate is degraded. On the other hand, in the case of a surface tension of less than 20 mN/m, fluidity of the metal salt mixture becomes too high, and it flows through the substrate surface too easily, whereby it is difficult to form a precise pattern.

Examples of such the surfactant and smoothing agent that are commercially available include dialkyl sulfosuccinates, alkylnaphthalene sulfonates, anionic surfactants such as fatty acid salts, polyoxyethylene alkylethers, polyoxyethylene alkylallylethers, acetylene glycols, nonionic surfactants such as polyoxyethylene-polyoxypropylene block copolymers, alkylamine salts, cationic surfactants such as quaternary ammonium salts and so forth. Specifically, anionic surfactants and nonionic surfactants are preferably usable. Of these, SURFYNOL and DYNOL produced by Air Products Japan, Inc. are particularly usable.

The metal salt mixture of the present invention may contain latex. The latex of the present invention means polymer particles dispersed in a medium. Examples of the polymer kind include a styrene-butadiene copolymer, polystyrene, an acrylonirile-butadiene copolymer, an acrylic acid ester copolymer, polyurethane, a silicon-acrylic copolymer and an acrylic modified fluorine resin. Of these, acrylic acid ester, polyurethane and a silicon-acrylic copolymer are preferable.

The addition amount is not particularly limited, but the addition amount is adjusted so as to be within the above-described viscosity range.

The metal salt mixture of the present invention also contains a polymer in a melt state. Examples of such the polymer kind include a block copolymer, a random copolymer and their salts composed of at least two kinds selected from the group consisting of styrene, a styrene derivative, a vinylnaphthalene derivative, an acrylic acid, an acrylic acid derivative, a maleic acid, a maleic acid derivative, an itaconic acid, an itaconic acid derivative, a fumaric acid and a fumaric acid derivative

### (Ligand)

The metal salt mixture of the present invention may contain a ligand. The ligand means a compound coordinated with metal, and complexation of the metal ion is conducted to increase stability in a mixture solution. Compounds listed as commonly known ligands are usable, and above all, preferably usable are a monodentate ligand containing a nitrogen atom such as pyridine, ammonia or alkylamine; a bidentate ligand containing an oxygen atom or a nitrogen atom such as ethylenediamine, bipyridine, phenanthroline, glycin, a glycolic acid, a tartaric acid or a citric acid; and a tridentate ligand or a polydentate ligand such as terpyridine, an ethylenediamine tetraacetic acid or crown ethers.

The addition amount of these ligands is not particularly limited, but a molar ratio of it to the metal ion is preferably 1 - 10. In the case of the ratio of less than 1, it is not preferred that a metal salt tends to be precipitated and settled out during storing the metal salt mixture, since ligand stability generated from a ligand and the metal salt mixture drops. On the other hand, in the case of the ratio exceeding 10, it is not preferred that a metal pattern of a desired film thickness tends not to be obtained, since the metal concentration in the metal salt mixture is reduced.

### (Physical development nucleus)

The physical development nucleus of the present invention means colloidal noble metal particles or colloidal heavy metal sulfide particles which are used for a silver halide photosensitive material, and examples thereof include colloidal silver particles, and colloidal palladium sulfide particles, nickel sulfide particles, silver-nickel sulfide particles and so forth.

No physical development nucleus is preferably contained substantially in the case of the present invention. In the present invention, no substantial content of the physical development nucleus means the upper limit of content of less than 0.05% by weight in a metal salt mixture. In the case of a substrate, the limit of content is less than 2 mg/m². In addition, when the metal salt mixture and the substrate each have the physical development nucleus, it is preferable that a physical development nucleus content index represented by A in the following equation is less than 1 in order to acquire effects of the present invention.

Physical development nucleus content index: A = B + C
wherein "B" is the number obtained by a content of physical development nucleus in a metal salt mixture (% by weight) divided by 0.05% by weight, and "C" is the number obtained by a content of physical development nucleus in a substrate (mg/m²) divided by 2 mg/m².

### EXAMPLE

### Example 1

Metal salt mixtures were prepared in combinations as shown in Table 1 and Table 2.

In addition, as to metal salt mixture 12 in combinations as shown in Table 1, copper (II) formate tetrahydrate [Cu(HCOO)₂·4H₂O] was charged into 3-methoxypropylamine at temperature of less than 50 °C in Ar atmosphere while stirring for 20 minutes, and the system was concentrated until the weight reached 65% by weight of the total weight.

The viscosity was measured at 25 °C employing VISCOMATE VM-1G produced by Yamaichi Electronics Co., Ltd., and the measured value was corrected in such a way that viscosity of water at 25 °C was 89 Pa·s.

**Table 1**

| Metal salt mixture No. | Additive kinds | | | | |
|---|---|---|---|---|---|
| | Metal salt mixture | Reducing agent | Ligand | Physical development nucleus dispersion | Solvent |
| 1 | Copper (II) acetate-hydrate | Tartaric acid | Ammonia water | Non | Non |
| 2 | Copper (II) acetate-hydrate | Hydrazine-hydrate | Ammonia water | Non | Non |
| 3 | Copper (II) acetate-hydrate | Hydrazine-hydrate | Ammonia water | Non | Diethylen glycol |
| 4 | Copper (II) acetate-hydrate | Hydrazine-hydrate | Ammonia water | Non | Diethylen glycol |
| 5 | Copper (II) acetate-hydrate | Hydrazine-hydrate | Ammonia water | Non | Diethylen glycol |
| 6 | Copper (II) acetate-hydrate | Hydrazine-hydrate | Ammonia water | Non | Diethylen glycol |
| 7 | Copper (II) acetate-hydrate | Ascorbic acid | Ammonia water | Non | Non |
| 8 | Copper (II) acetate-hydrate | Ethylene diamine | Non | Non | Ethylen glycol |
| 9 | Copper (II) acetate-hydrate | Citric acid-hydrate | Ammonia water | Non | Ethylen glycol |
| 10 | Copper (II) acetate-hydrate | Citric acid-hydrate | Ammonia water | Non | Non |
| 11 | Copper (II) acetate-hydrate | Citric acid-hydrate | Ammonia water | Non | Ethylen glycol |
| 12 | Copper (II) formate tetra hydrate | 3-methoxy propyl amine | Non | Non | Non |
| 13 | Copper (II) acetate-hydrate | Hydrazine-hydrate | Ammonia water | N^{*1} | Diethylen glycol |
| 14 | Copper (II) acetate-hydrate | Hydrazine-hydrate | Ammonia water | N^{*1} | Diethylen glycol |
| 15 | Silver nitrate | 3-amino propanol | Non | Non | Diethylen glycol |
| 16 | Silver nitrate | 3-amino propanol | Non | N^{*1} | Diethylen glycol |
| 17 | Potassium tetrachloro platinum (II) acid | 3-amino propanol | Non | Non | Diethylen glycol |
| 18 | Potassium tetrachloro palladium (II) acid | 3-amino propanol | Non | Non | Diethylen glycol |
| 19 | Tetrachloro gold (III) acid tetrahydrate | 3-amino propanol | Non | Non | Diethylen glycol |

| | | | | | |
|---|---|---|---|---|---|
| *1 Physical development nucleus N: Aqueous 5.6% gelatin solution containing 0.01 mol/L of colloidal Ag₂S-NiS nucleus | | | | | |

**Table 2**

| Metal salt mixture No. | Additives | | | | | | *b | *c | *d |
|---|---|---|---|---|---|---|---|---|---|
| | Metal salt mixture (% by weight) | Reducing agent (% by weight) | Ligand (% by weight) | *a (% by weight) | Solvent (% by weight) | Water (% by weight) | | | |
| 1 | 20 | 18 | 19 | 0 | 0 | 43 | 4.7 | 51.1 | Inv |
| 2 | 20 | 6 | 19 | 0 | 0 | 55 | 1.6 | 51.9 | Comp |
| 3 | 20 | 6 | 19 | 0 | 3 | 52 | 3.2 | 51.2 | Inv |
| 4 | 20 | 6 | 19 | 0 | 4 | 51 | 3.8 | 50.9 | Inv |
| 5 | 20 | 6 | 19 | 0 | 27.5 | 27.5 | 15.9 | 45.3 | Inv |
| 6 | 20 | 6 | 19 | 0 | 51 | 4 | 28.0 | 38.7 | Inv |
| 7 | 20 | 21 | 25 | 0 | 0 | 34 | 19.2 | 46.7 | Inv |
| 8 | 20 | 18 | 0 | 0 | 31 | 31 | 13.8 | 52.5 | Inv |
| 9 | 20 | 29 | 21 | 0 | 15 | 15 | 39.1 | 46.6 | Inv |
| 10 | 20 | 46 | 21 | 0 | 0 | 13 | 47.3 | 47.2 | Inv |
| 11 | 20 | 46 | 21 | 0 | 2 | 11 | 66.2 | 47.0 | Comp |
| 12 | 20 | 70 | 0 | 0 | 0 | 0 | 187 | 36.6 | Comp |
| 13 | 20 | 6 | 19 | 8.9 (0.03) | 27.5 | 18.6 | 16.3 | 45.1 | Inv |
| 14 | 20 | 6 | 19 | 14.8 (0.05) 0 | 27.5 | 12.7 | 17.4 | 45.0 | Inv |
| 15 | 7 | 7 | 0 | | 36 | 50 | 4.5 | 54.5 | Inv |
| 16 | 7 | 7 | 0 | 8.9 (0.03) | 36 | 50 | 4.5 | 54.1 | Inv |
| 17 | 7 | 9 | 0 | 0 | 35 | 49 | 4.8 | 54.2 | Inv |
| 18 | 7 | 7 | 0 | 0 | 55 | 31 | 5.5 | 51.3 | Inv |
| 19 | 7 | 17 | 0 | 0 | 34 | 42 | 6.4 | 52.5 | Inv |

| | | | | | | | | | |
|---|---|---|---|---|---|---|---|---|---|
| *a: Physical development nucleus dispersion (Content^{*1} % by weight) *1: The value converted into the content of physical development nucleus in the metal salt mixture *b: Viscosity mPa·s *c: Surface tension mN/m *d: Remarks Inv: Present invention Comp: Comparative example | | | | | | | | | |

The pattern of 100 straight-lines was made on a substrate with the resulting metal salt mixture under the condition of a given pressure employing a dispenser (MS-10DX-V7, manufactured by Musashi Engineering, Inc.). Herein, a metal needle having an inner diameter of 0.10 mm was used as a needle, and three types of substrates described below were used as the substrate.

### Substrate No. 1: Polyethylene terephthalate film (a thickness of 100 µm)

On the substrate surface, coated was 5.70 g/m² of an aqueous 0.05% by weight polyvinyl alcohol solution containing 0.0038 mol/L of colloidal PdS nucleus and 0.01% by weight of surfactant (OLFIN E-1010, produced by Nisshin Chemical Industry Co., Ltd.), and the system was dried (a content of colloidal PdS nucleus of 3 mg/m²) .

### Substrate No. 2: Polyethylene terephthalate film (a thickness of 100 µm)

On the substrate surface, coated was 1.90 g/m² of an aqueous 0.05% by weight polyvinyl alcohol solution containing 0.0038 mol/L of colloidal PdS nucleus and 0.01% by weight of surfactant (OLFIN E-1010, produced by Nisshin Chemical Industry Co., Ltd.), and the system was dried (a content of colloidal PdS nucleus of 1 mg/m²).

### Substrate No. 3: Polyimide film whose surface has been subjected to a plasma treatment (a thickness of 140 µm)

The surface of this substrate was analyzed employing an X-ray photoelectron spectrometer (ESCALAB 200R, manufactured by V.G. Scientific Ltd.), but no metal nucleus was detected.

After conducting patterning, the substrate was directly placed in an electric furnace to be heated at 180 °C for one hour.

After heating, the system was cooled at room temperature, the metal pattern was made on a substrate in the form of a pattern, and then it was confirmed for the pattern to be good electrically conductive.

### (Evaluation method)

### Line width

The line width of metal patterns was first evaluated. Ten out of patterns obtained from each metal salt mixture were pulled off to measure each of line widths. The average line width of patterns obtained from each of metal salt mixtures was determined, and comparison was made to each other. How much line width was increased with respect to the narrowest line width reference was evaluated by the following criteria.
A: The increased width is within 10% with respect to the narrowest line width reference.
B: The increased width is 10 - 20% with respect to the narrowest line width reference.
C: The increased width is more than 20% with respect to the narrowest line width reference.

### Flexibility

A stainless bar having an outer diameter of 1 cm was brought into contact with the back surface of a substrate, and after bending the substrate at an angle of 90°, the operation to put it back to the original position was repeated 20 times.

After this, whether conductivity varies before or after the bending test concerning flexibility or not was evaluated via measurement of electrical resistance by the following criteria.
A: No substantial change of electrical resistance
B: Increase of electrical resistance (up to 10 times)
C: Large increase of electrical resistance (more than 10 times)

### Adhesiveness

The peeling test of tape samples was conducted in accordance with JIS D0202-1988. The evaluation sample having a pattern of 1 mm resulting in 10 separated squares in total was made, and a cellophane tape (CT24, produced by Nichiban Co., Ltd.) was attached on a film by a finger cushion, and was subsequently peeled off. How many squares were peeled off out of 10 separated squares were evaluated by the following criteria.
A: one separated square or less was peeled off.
B: Two to four separated squares were peeled off.
C: Five separated squares or more were peeled off.

Results are shown in Table 3.

**Table 3**

| Metal pattern No. | Metal salt mixture No. | Subst Rate No. | *1 | Line width | Conductivity | Adhesiveness | Remarks |
|---|---|---|---|---|---|---|---|
| 1 | 1 | 3 | 0 | B | A | A | Inv |
| 2 | 2 | 3 | 0 | C | C | B | Comp |
| 2 | 3 | 3 | 0 | B | B | B | Inv |
| 2 | 4 | 3 | 0 | B | B | A | Inv |
| 3 | 5 | 3 | 0 | A | A | A | Inv |
| 4 | 6 | 3 | 0 | A | A | A | Inv |
| 5 | 7 | 3 | 0 | A | A | A | Inv |
| 6 | 8 | 3 | 0 | A | A | B | Inv |
| 6 | 9 | 3 | 0 | A | B | B | Inv |
| 7 | 10 | 3 | 0 | B | B | B | Inv |
| 8 | 11 | 3 | 0 | B | C | C | Comp |
| 9 | 12 | 3 | 0 | B | C | C | Comp |
| 10 | 13 | 3 | 0.6 | A | A | B | Inv |
| 11 | 14 | 3 | 1.0 | A | B | B | Inv |
| 12 | 5 | 1 | 1.5 | B | B | B | Inv |
| 13 | 5 | 2 | 0.5 | A | A | B | Inv |
| 14 | 13 | 2 | 1.1 | A | B | B | Inv |
| 15 | 15 | 3 | 0 | A | A | B | Inv |
| 16 | 16 | 3 | 0.6 | B | A | B | Inv |
| 17 | 17 | 3 | 0 | B | A | B | Inv |
| 18 | 18 | 3 | 0 | A | A | B | Inv |
| 19 | 19 | 3 | 0 | A | A | B | Inv |

| | | | | | | | |
|---|---|---|---|---|---|---|---|
| *1: Physical development nucleus content index Inv: Present invention Comp: Comparative example | | | | | | | |

As is clear from Table 3, it is to be understood that samples of the present invention exhibit conductivity as well as flexibility. On the other hand, it is found out that comparative examples exhibit large degradation in conductivity and flexibility after the bending test.

### Example 2

An ink-jet head (KM256Aq aqueous type head) was installed in an ink-jet head evaluation apparatus (EB100, manufactured by Konica Minolta IJ Technologies, Inc.) equipped with conveyance system option XY100, and metal patterns were made with the metal salt mixture prepared in Example 1. Evaluations of conductivity and flexibility were made similarly to Example 1, and the same results were obtained.

### Example 3

### Storage property 1: Conductivity

Similarly, line patterns were lithographically drawn employing the resulting metal salt mixture and a reducing agent mixture to evaluate conductivity. After storing the resulting line patterns at 45 °C and 70%RH for one month, conductivity after the storage was evaluated. The conductivity before and after the storage was evaluated according to the following criteria.
A: No substantial change of electrical resistance
B: Increase of electrical resistance (up to 10 times)
C: Large increase of electrical resistance (more than 10 times)

### Storage property 2: Adhesiveness

Adhesiveness was further evaluated. The peeling test of tape samples was conducted in accordance with JIS D0202-1988. As to each of lithographically drawn patterns before and after the storage at 45 °C and 70%RH for one month, the evaluation sample having each of the patterns of 1 mm resulting in 10 separated squares in total was made, and a cellophane tape (CT24, produced by Nichiban Co., Ltd.) was attached on a film by a finger cushion, and was subsequently peeled off. How many squares were peeled off out of 10 separated squares before and after the storage were evaluated by the following criteria.
A: The number difference of peeled-off separated squares before and after the storage is 1 or less.
B: The number difference of peeled-off separated squares before and after the storage is 2 or 3.
C: The number difference of peeled-off separated squares before and after the storage is 4 or more.

Results are shown in Table 4.

**Table 4**

| Metal salt mixture No. | Substrate No. | Evaluation results of storage | | Remarks |
|---|---|---|---|---|
| | | Conductivity | Adhesiveness | |
| 2 | 3 | C | C | Comp |
| 3 | 3 | A | A | Inv. |
| 5 | 3 | A | A | Inv. |
| 6 | 3 | A | A | Inv. |
| 7 | 3 | A | A | Inv. |
| 8 | 3 | A | A | Inv. |
| 10 | 3 | A | A | Inv. |
| 11 | 3 | C | C | Comp |
| 15 | 3 | B | B | Inv. |
| 16 | 3 | B | C | Inv. |
| 17 | 3 | B | B | Inv. |
| 18 | 3 | B | B | Inv. |
| 19 | 3 | B | B | Inv. |

| | | | | |
|---|---|---|---|---|
| Comp: Comparative example Inv: Present invention | | | | |

As is clear from Table 4, it is to be understood that samples of the present invention exhibit excellent conductivity and adhesiveness evaluated via storage. It is also understood that samples specifically utilizing copper exhibit substantially no performance degradation before and after the storage.

### [EFFECT OF THE INVENTION]

In the present invention, provided can be plate making printing exhibiting conductivity and flexibility with respect to a flexible substrate, and to provide a method of forming metal patterns via non-plate making printing, and a metal salt mixture usable for the method.

## Claims

1. A method of forming a metal pattern comprising the steps of:
(a) conducting patterning on a substrate with a metal salt mixture for the metal pattern formation comprising a metal salt and a reducing agent, and having a viscosity of 3 - 50 mPa·s at 25 °C; and
(b) forming the metal pattern via heating.

2. The method of Claim 1,
wherein the metal salt mixture further comprises a solvent.

3. The method of Claim 1,
wherein the metal is gold, silver, copper, platinum, palladium or nickel.

4. The method of Claim 3,
wherein the metal is copper.

5. The method of Claim 1,
wherein no physical development nucleus is substantially contained in the metal salt mixture and on a substrate.

6. The method of Claim 1,
wherein the metal salt mixture has a viscosity of 3.5 - 40 mPa·s at 25 °C.

7. The method of Claim 6,
wherein the metal salt mixture has a viscosity of 4 - 30 mPa·s at 25 °C.

8. The method of Claim 1,
wherein the metal salt mixture has a surface tension of 20 - 60 mN/m.

9. The method of Claim 8,
wherein the metal salt mixture has a surface tension of 25 - 50 mN/m.

10. The method of Claim 1,
wherein the metal salt mixture comprises water.

11. The method of Claim 2,
wherein the metal salt mixture comprises a water-soluble organic solvent as the solvent.

12. The method of Claim 2,
wherein the metal salt mixture comprises a water-insoluble organic solvent as the solvent.

13. The method of Claim 1,
wherein the substrate is flexible.

14. The method of Claim 1,
wherein the metal pattern has a line width of 10 - 200 µm.

15. The method of Claim 1,
wherein the heating temperature is 80 - 800 °C.

16. A metal salt mixture for metal pattern formation,
wherein the metal salt mixture comprising a metal salt and a reducing agent has a viscosity of 3 - 50 mPa·s at 25 °C.

17. The metal salt mixture of Claim 16, further comprising a solvent.

18. The metal salt mixture of Claim 16,
wherein the metal is gold, silver, copper, platinum, palladium or nickel.

19. The metal salt mixture of Claim 18,
wherein the metal is copper.

20. The metal salt mixture of Claim 16, substantially comprising no physical development nucleus.

21. The metal salt mixture of Claim 16, having a viscosity of 3.5 - 40 mPa·s at 25 °C.

22. The metal salt mixture of Claim 21, having a viscosity of 4 - 30 mPa·s at 25 °C.

23. The metal salt mixture of Claim 16, having a surface tension of 20 - 60 mN/m.

24. The metal salt mixture of Claim 23, having a surface tension of 25 - 50 mN/m.

25. The metal salt mixture of Claim 16, comprising water.

26. The metal salt mixture of Claim 17, comprising a water-soluble organic solvent as the solvent.

27. The metal salt mixture of Claim 17, comprising a water-insoluble organic solvent as the solvent.
